# EUROPEAN PATENT APPLICATION

(11) **EP 0 825 656 A2**
(43) Date of publication of application: **25.02.1998**
(21) Application number: 97401923.4
(22) Date of filing: 13.08.1997
(51) Int. Cl.: H01L 39/14

(54) **Superconducting film structure comprising oxide superconductor layer and protective layer and method for preparing the same**

(30) Priority: 13.08.1996 JP 231517/96
(71) Applicant: SUMITOMO ELECTRIC INDUSTRIES, LIMITED, Osaka 541 (JP)
(72) Inventor: Nakamura, Takao, 1-3, Shimaya 1-chome, Konohana-ku, Osaka (JP); Inada, Hiroshi, 1-3, Shimaya 1-chome, Konohana-ku, Osaka (JP); Iiyama, Michitomo, 1-3, Shimaya 1-chome, Konohana-ku, Osaka (JP)
(74) Representative: Ballot, Paul Denis Jacques

(57) **Abstract**

The invention provides a superconducting film structure comprising an oxide superconductor layer and a protective layer which covers and protects a surface of the oxide superconductor layer .

## Description

### Background of the Invention

### Field of the invention

The present invention relates to a superconducting film structure having an oxide superconductor layer and method for preparing the superconducting film structure, and more specifically to a superconducting film structure having an oxide superconductor and a protective layer, which is not degraded in the air, and method for preparing the superconducting film structure, which is preferably applied to forming a gate structure of a superconducting field effect transistor including a superconducting channel of oxide superconductor, a gate insulator and a gate electrode stacked in the named order.

### Description of related art

The oxide superconductor, for example the Y-Ba-Cu-O type oxide superconductor, the Bi-Sr-Ca-Cu-O type oxide superconductor, the Tl-Ba-Ca-Cu-O type oxide superconductor, is prone to be decomposed amorphous oxide which is no longer a superconductor by carbon dioxide and vapor in the atmosphere. By this, films of oxide superconductor material are covered with the amorphous oxide layer. Thus, superconducting devices utilizing the oxide superconductor films may not have expected properties or the oxide superconductor films may lose the superconductivity.

The oxide superconductor thin film is used for superconducting devices utilizing the oxide superconductor material. One of the most important three-terminal superconducting devices is a field effect transistor type superconducting device (abbreviated as super-FET hereinafter) having a channel of a superconductor formed between a source and a drain. In this superconducting device, a current flowing through the superconducting channel is controlled by a signal voltage applied to a gate formed above the superconducting channel.

The super-FET mentioned above is a voltage controlled device which is capable of isolating output signals from input ones and of having a well defined gain. In addition, it has a large current capability.

The above super-FET has a superconducting channel formed of an oxide superconductor thin film having a thickness of on the order of 5 nanometers. There is a possibility to vanish an active region of the super-FET by the formation of the amorphous layer. In order to prevent this inconvenience, main steps of the process for manufacturing the super-FET should be conducted in ultra high vacuum, or all the exposed portion of the oxide superconductor films should be covered with protective layers. Although it is possible to conduct all the steps of the process for manufacturing the super-FET in ultra high vacuum, there are many advantages such as increase in degree of freedom of the steps, facility of the processings, increase in degree of freedom of materials in processings in the atmosphere and in processings using an apparatus other than the ultra high vacuum one.

On the other hand, there are limitations in material and method for preparing the protective layer. The protective layer must not take oxygen from the protected oxide superconductor thin film and interlayer diffusion must not occur between the protective layer and the protected oxide superconductor thin film during the process for preparing the protective layer. In addition, since there is a large thermal difference between the temperatures of the processings and of the operation, it is required that there is no mechanical distortion hetween the protective layer and the protected oxide superconductor thin film and that the protective layer has a thermal coefficient similar to that of the oxide superconductor.

Furthermore, when the protective layer is needed in a intermediate step of the process for manufacturing the superconducting device, the protective layer should succeed to and transmit the crystallinity of the protected oxide superconductor thin film to upper layers to be deposited on the protective layer. This means that the protective layer should have a crystal structure and lattice parameters similar to those of the oxide superconductor. In this case, processability of the protective layers is also required. For example, it may be necessary that the protective layer is selectively removed to expose a portion of the oxide superconductor thin film. In this case, it is required that no contaminant is remained on the exposed surface of the oxide superconductor thin film, that there is an appropriate method for removing the protective layer which has a removing rate for the protective layer enough higher than for the oxide superconductor, and that it is possible to apply patterning techniques such as photolithography techniques.

In earlier technology, the emphasis has been on using the protective layer to prevent degradation of properties of the oxide superconductor thin film with time. There is little discussion of the protective layer focusing on prevention on degradation of the oxide superconductor thin film which occurs just after deposition by means of exposure of the atmosphere.

Therefore, in earlier technology, the protective layer is often prepared by an apparatus other than the high vacuum apparatus for depositing the oxide superconductor thin film. In this case, the oxide superconductor thin film is taken from the high vacuum apparatus into the air after deposition and transferred to the apparatus for depositing the protective layer. The protective layer sometimes prepared in the atmosphere. Silicon oxide, silicon nitride, some resins and other materials which have been used for passivation layers or protective layers of semiconductor devices are used in the earlier technology. Thus, it is impossible to prevent degradation of a surface of the oxide superconductor thin film before formation of the protective layer so that there has been an amorphous oxide layer which is formed by decomposition of the oxide superconductor between the protective layer and the oxide superconductor.

### Summary of the Invention

Accordingly, it is an object of the present invention to provide a superconducting film structure having an oxide superconductor and a protective layer which overcomes the above defects of the prior art.

Another object of the present invention is to provide a method for preparing a superconducting film structure having an oxide superconductor and a protective layer on its surface.

The above and other objects of the present invention are achieved in accordance with the present invention by a superconducting film structure comprising an oxide superconductor layer and a protective layer which covers and protects a surface of the oxide superconductor layer.

According to another aspect of the present invention, there is provided a superconducting device comprising a layered structure having a lower layer of an oxide superconductor and an upper layer of a material different from the oxide superconductor wherein the upper layer protects the oxide superconductor layer.

According to still another aspect of the present invention, there is provided a method for preparing on a substrate a superconducting film structure comprising a lower thin film composed of an oxide superconductor and a protective layer composed of a material different from the oxide superconductor which covers and protects a surface of the oxide superconductor layer wherein the protective layer is formed without breaking the vacuum and without transfer of the substrate.

The protective layer can be formed of at least one of SrTiO₃ (abbreviated as STO hereinafter), BaTiO₃ (abbreviated as BTO hereinafter), BaₓSr₁₋ₓTiO₃ (0<x<1; abbreviated as BSTO hereinafter). The protective layer may be formed of more than two oxides selected from a group consisting of STO, BTO, and BSTO. The protective layer can be also formed of BaₓSr₁₋ₓTiO₃ (0≤x≤1) in which x has the largest value at a side contact with the oxide superconducting layer, the smallest value at the opposite side and continuously decreases with distance from the oxide superconducting layer increasing.

For protection of the oxide superconductor layer, the protective layer can have a thickness of some nanometers. However, if the protective layer has other functions, the thickness of the protective layer may be determined by the presence or absence of processing of the protective layer and the prevention of interdiffusion between the oxide superconductor layer and the protective layer. The protective layer can usually have a thickness of 1 - 100 nanometers.

The superconducting film structure may further comprise a metal layer on the protective layer, which is alloyed with the protective layer so that the metal layer is electrically connected to the oxide superconductor layer. In this case, the metal layer becomes an ohmic electrode which can electrically connect the oxide superconductor thin film to the outside. The metal layer can be formed with heating for enhancement of the alloying. The metal layer may be heated after deposition for enhancement of the alloying. The metal layer can be heated by lamp annealing, by laser annealing, or by using a furnace. The metal layer can be formed by using an apparatus other than the one used for forming the oxide superconductor layer and the protective layer. Because, the oxide superconductor layer is already protected by the protective layer when the metal layer is formed. In this connection, the protective layer can be formed of STO and the metal layer is formed of one of Ti, Nb, Ni, Ag, Au which can be easily alloyed with STO.

In a preferred embodiment, the oxide superconductor can be formed of a high-T_{c} (high critical temperature) oxide superconductor, particularly, formed of a high-T_{c} copper-oxide type compound oxide superconductor for example a Y-Ba-Cu-O type compound oxide superconductor material, a Bi-Sr-Ca-Cu-O type compound oxide superconductor material, and a Tl-Ba-Ca-Cu-O type compound oxide superconductor material.

The above and other objects, features and advantages of the present invention will be apparent from the following description of preferred embodiments of the invention with reference to the accompanying drawings.

### Brief Description of the Drawings

Figure 1 is a graph showing variations with time of critical temperatures of Y₁Ba₂Cu₃O₇₋ₓ oxide superconductor thin films according to the invention;
Figure 2 is a graph showing variations with time of critical temperatures of Y₁Ba₂Cu₃O₇₋ₓ oxide superconductor thin films without protective layer;
Figures 3A-3G show a process for manufacturing the device structure of a super-FET having a Y₁Ba₂Cu₃O₇₋ₓ oxide superconductor and a protective layer in accordance with the invention prepared by a method according to the invention;
Figure 4 shows the drain current-voltage characteristics of the super-FET manufactured by the process shown in Figure 3A-3G; and
Figure 5 shows a comparison of the transconduction gₘ as a function of normalized operating temperature (T/T_{c}) for various device structures.

### Description of the Preferred embodiments

### Embodiment 1

A superconducting film structure having a Y₁Ba₂Cu₃O₇₋ₓ oxide superconductor layer and a STO protective layer in accordance with the invention was prepared by a method according to the invention

At first, a Y₁Ba₂Cu₃O₇₋ₓ oxide superconductor thin film was deposited on a STO (100) substrate by pulsed laser deposition. The deposition condition was as follows:

| | |
|---|---|
| Substrate Temperature | 690 °C |
| Deposition Atmosphere | 0.3 Torr (39.99 Pa) |
| Depositing Duration | 1 min. |
| Film Thickness | 11 nm |

Then, a protective layer of STO was continuously deposited on the Y₁Ba₂Cu₃O₇₋ₓ oxide superconductor thin film by pulsed laser deposition without breaking the vacuum. The deposition condition was as follows:

| | |
|---|---|
| Substrate Temperature | 600 °C |
| Deposition Atmosphere | 0.03 Torr (3.999 Pa) |
| Depositing Duration | 3 sec. |
| Film Thickness | 3 nm |

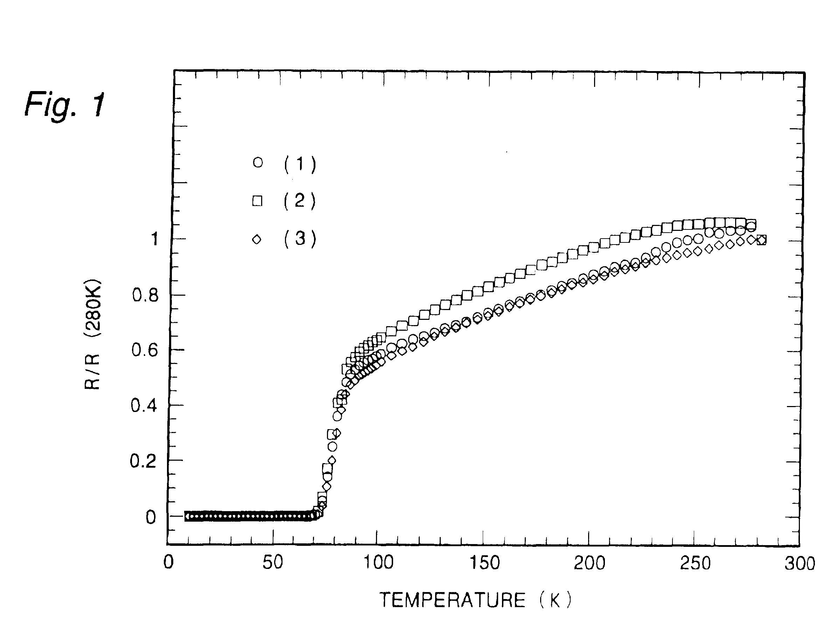

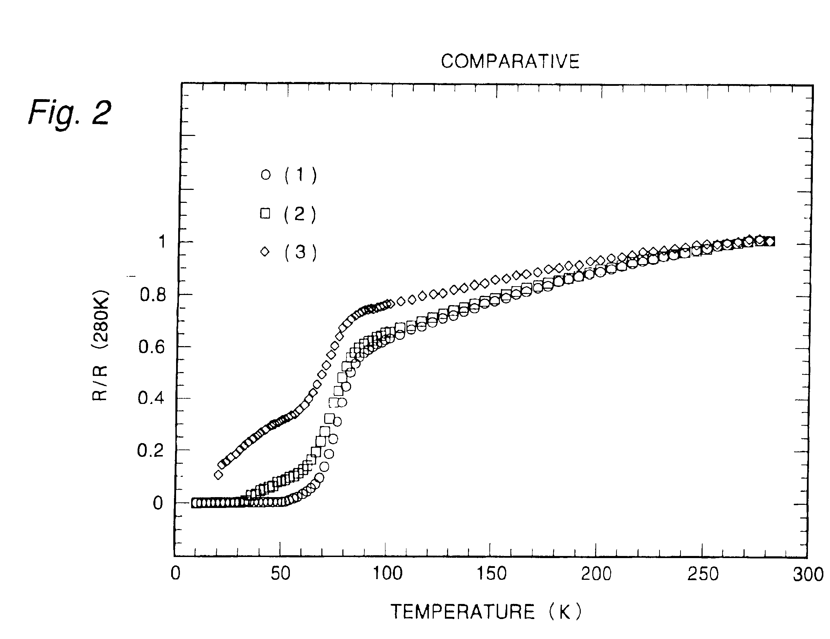

The specimen was divided into three pieces and superconducting properties of the lower Y₁Ba₂Cu₃O₇₋ₓ, oxide superconductor thin film of the above layered structure were measured just after deposition, after one day and after four days. The critical temperatures of the Y₁Ba₂Cu₃O₇₋ₓ oxide superconductor thin films of the above layered structure according to the invention were shown in Figure 1. The critical temperatures of the Y₁Ba₂Cu₃O₇₋ₓ oxide superconductor thin films deposited under the same condition but having no protective layer were shown in Figure 2. In Figures 1 and 2, (1) show the measurements of the critical temperatures just after the deposition, (2) show the measurements of the critical temperatures after one day and (3) show the measurements of the critical temperatures after four days.

As shown in Figures 1 and 2, the critical temperatures of the oxide superconductor layers of the superconducting film structure according to the invention were 69.5 K just after deposition, 65.2 K after one day and 65.4 K after four days, which were little changed. On the other hand, the critical temperatures of the oxide superconductor thin films without protective layers were 47.1 K just after deposition and 26.3 K after one day, and superconducting transition did not occur with the films after four days. The resistance was 3 ohms at 16 K.

The protective layer according to the invention prevents degradation of properties of the oxide superconductor thin film when it is taken from the high vacuum into the air after deposition as well as degradation with time.

### Embodiment 2

A superconducting film structure having a Y₁Ba₂Cu₃O₇₋ₓ oxide superconductor layer and a BSTO (Ba_{0.5}Sr_{0.5}TiO₃) protective layer in accordance with the invention was prepared by a method according to the invention.

At first, a Y₁Ba₂Cu₃O₇₋ₓ oxide superconductor thin film was deposited on a STO (100) substrate by pulsed laser deposition under a condition equal to Embodiment 1.

Then, a protective layer of BSTO (Ba_{0.5}Sr_{0.5}TiO₃) was continuously deposited on the Y₁Ba₂Cu₃O₇₋ₓ oxide superconductor thin film by pulsed laser deposition without breaking the vacuum. The deposition condition was as follows:

| | |
|---|---|
| Substrate Temperature | 600 °C |
| Deposition Atmosphere | 0.03 Torr (3.999 Pa) |
| Depositing Duration | 3 sec. |
| Film Thickness | 3 nm |

The specimen was divided into two pieces and superconducting properties of the lower Y₁Ba₂Cu₃O₇₋ₓ oxide superconductor thin film of the above layered structure were measured just after deposition and after seven days. The lower Y₁Ba₂Cu₃O₇₋ₓ oxide superconductor thin films had the critical temperatures of 73.2 K just after the deposition and 73 K after seven days.

The protective layer according to the invention prevents degradation of properties of the oxide superconductor thin film when it is taken from the high vacuum into the air after deposition as well as degradation with time.

### Embodiment 3

A superconducting film structure having a Y₁Ba₂Cu₃O₇₋ₓ oxide superconductor layer and a protective layer of an alloy of STO and Ti in accordance with the invention was prepared by a method according to the invention.

A Y₁Ba₂Cu₃O₇₋ₓ oxide superconductor thin film having a thickness of 33 nanometers was deposited on a STO (100) substrate, a protective layer of STO having a thickness of 11 nanometers was deposited on the Y₁Ba₂Cu₃O₇₋ₓ oxide superconductor thin film without breaking the vacuum and without transfer of the substrate. The STO protective layer and the Y₁Ba₂Cu₃O₇₋ₓ oxide superconductor thin film were deposited by pulsed laser deposition under conditions equal to Embodiment 1. Then, a electrode of Ti layer was formed by vapor deposition on the protective layer and it was alloyed with the protective layer so that the oxide superconductor thin film was electrically connected to the electrode. The condition of depositing the Ti layer was as follows:

| | |
|---|---|
| Substrate Temperature | Room Temperature |
| Vapor Source | Ti |
| Depositing Duration | 20 min. |
| Film Thickness | 150 nm |
| Contact Resistance | 15.8 Ωcm² |

Then, in order to stimulate the alloying, the Ti electrode layer was heated by lamp annealing under the following condition:

| | |
|---|---|
| Heating Duration | 1 min. |
| Atmosphere | Vacuum |
| Contact Resistance | 1 × 10⁻³ Ωcm² |

The above electrode was formed on the protective layer so that it did not directly contact with the oxide superconductor thin film. Therefore, the oxide superconductor thin film was not degraded. In addition, steps for forming an opening in the protective layer were not necessary. Furthermore, an usual method for forming a electrode layer, for example selective etching process, lift off process, metal mask process could be applied so that the electrode was formed with high accuracy without adverse effect of a step portion.

### Embodiment 4

A superconducting thin film structure having a Y₁Ba₂Cu₃O₇₋ₓ oxide superconductor layer and a STO protective layer in accordance with the invention was prepared by another method according to the invention.

At first, a Y₁Ba₂Cu₃O₇₋ₓ oxide superconductor thin film was deposited on a STO (100) substrate by molecular beam epitaxy (MBE). The deposition condition was as follows:

| | |
|---|---|
| Substrate Temperature | 700 °C |
| Deposition Atmosphere | 5 × 10⁻⁵ Torr (6.665 × 10⁻³ Pa; O₃) (in the vicinity of the substrate) |
| Deposition Duration | 20 min. |
| Film Thickness | 10 nm |

Then, a protective layer of STO was continuously deposited on the Y₁Ba₂Cu₃O₇₋ₓ oxide superconductor thin film by MBE without breaking the vacuum. The deposition condition was as follows:

| | |
|---|---|
| Substrate Temperature | 500 °C |
| Deposition Atmosphere | 5 × 10⁻⁵ Torr (6.665 × 10⁻³ Pa; O₃) (in the vicinity of the substrate) |
| Deposition Duration | 3 min. |
| Film Thickness | 3 nm |

The specimen was divided into three pieces and superconducting properties of the lower Y₁Ba₂Cu₃O₇₋ₓ oxide superconductor thin film of the above superconducting film structure were measured just after deposition, after one day and after four days. The critical temperatures of the Y₁Ba₂Cu₃O₇₋ₓ oxide superconductor thin films according to the invention were 73.8 K just after deposition, 73.5 K after one day and 73.7 K after four days, which were little changed.

### Embodiment 5

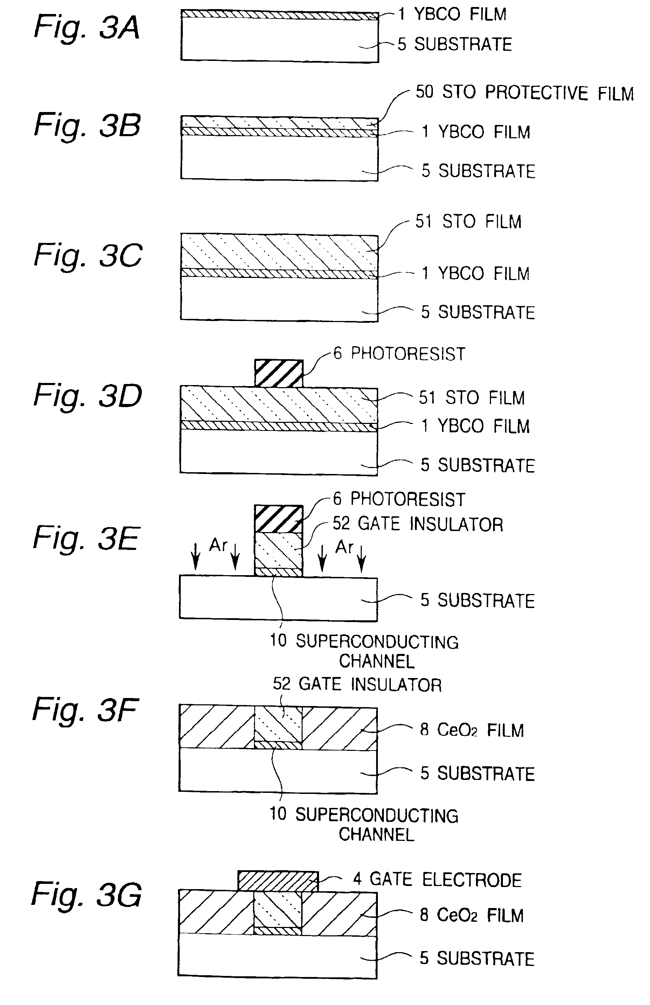

A device structure of a super-FET using a superconducting film structure having a Y₁Ba₂Cu₃O_{7-X} oxide superconductor and a protective layer in accordance with the invention prepared by a method according to the invention was manufactured. Referring to Figures 3A to 3G, the process for manufacturing the device structure will be explained.

At first, a Y₁Ba₂Cu₃O₇₋ₓ oxide superconductor thin film 1 was deposited on a STO (100) substrate 5 by MBE, as shown in Figure 3A. The deposition condition was as follows:

| | |
|---|---|
| Substrate Temperature | 700 °C |
| Deposition Atmosphere | 5 × 10⁻⁵ Torr (6.665 × 10⁻³ Pa; O₃) (in the vicinity of the substrate) |
| Deposition Duration | 10 min. |
| Film Thickness | 5 nm |

Then, a protective layer of STO 50 was continuously deposited on the Y₁Ba₂Cu₃O₇₋ₓ oxide superconductor thin film 1 by MBE without breaking the vacuum, as shown in Figure 3B. The deposition condition was as follows:

| | |
|---|---|
| Substrate Temperature | 500 °C |
| Deposition Atmosphere | 5 × 10⁻⁵ Torr (6.665 × 10⁻³ Pa; O₃) (in the vicinity of the substrate) |
| Deposition Duration | 3 min. |
| Film Thickness | 3 nm |

Thereafter, a STO film 51 having a thickness of 400 nanometers was deposited on the protective layer 50 by pulsed laser deposition under a condition equal to that of Embodiment 1, as shown in Figure 3C. A photoresist layer 6 was formed on a portion of the STO film 50, as shown in Figure 3D, so that the STO film 50 and the Y₁Ba₂Cu₃O₇₋ₓ oxide superconductor thin film 1 were etched by ion milling using Ar ions so as to form a gate insulator 52 and a superconducting channel 10, as shown in Figure 3E. Portions of the STO substrate 5 at the both sides of the superconducting channel 10 were exposed by the etching.

A CeO₂ layer 8 was deposited at the room temperature and a portion of the CeO₂ layer on the photoresist was removed by lift-off method so that the CeO₂ layer 8 was remained on the exposed portions of the STO substrate, as shown in Figure 3F. Finally, a gate electrode 4 having a thickness of 100 nanometers was formed of Ag by evaporation at the room temperature, as shown in Figure 3G. Thus, the device structure using a superconducting thin film structure in accordance with the invention was completed.

Superconducting properties of the lower Y₁Ba₂Cu₃O₇₋ₓ oxide superconductor thin film of the above device structure were measured just after deposition, and after the device was completed. The critical temperatures of the Y₁Ba₂Cu₃O₇₋ₓ oxide superconductor thin films of the the above device structure were 71.4 K just after deposition, and 66.7 K after the device was completed. The drop of the critical temperature was within 5 degrees after the device was completed.

Then, a source and a drain electrodes (not shown) were formed in contact with the both ends of the superconducting channel 10 so that characteristics of the device were evaluated.

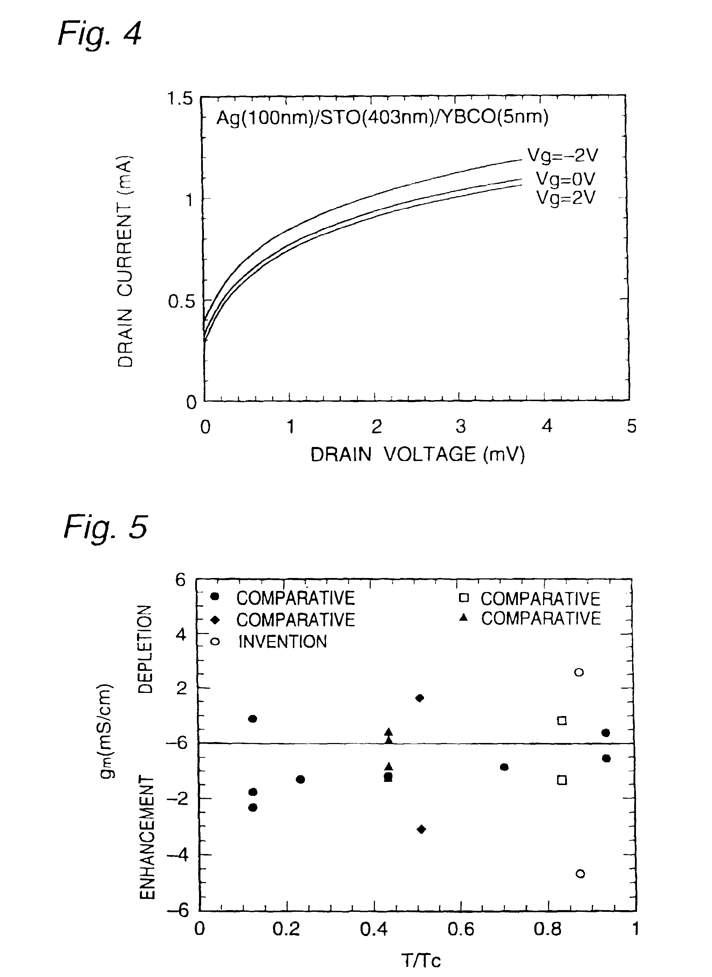

Figure 4 shows the drain current-voltage characteristics of the super-FET. The modulation factor of the superconducting current was 5 % in depletion mode and 10 % in enhancement mode.

Figure 5 shows a comparison of the transconduction gₘ as a function of normalized operating temperature (T/T_{c}) for various device structures. In Figure 5, the transconduction values of the above device structure using a superconducting film structure in accordance with the invention were indicated by white circles and the values of the other devices were indicated by black dots, black rhombi, white squares and black triangles. As shown in Figure 5, the device structure using a superconducting film structure in accordance with the invention had the best properties.

As explained above, a superconducting film structure having an oxide superconductor layer covered with and protected by a protective layer is provided in accordance with the present invention. The superconducting film structure in accordance with the present invention can be favorably applied to the superconducting device in which the oxide superconductor layer and protective layer constitute elements of the device. In addition, when a metal layer is formed on the protective layer and it is alloyed with the protective layer, the metal layer can be an electrode which is electrically connected to the oxide superconductor layer.

The invention has thus been shown and described with reference to the specific embodiments. However, it should be noted that the present invention is in no way limited to the details of the illustrated structures but converts and modifications may be made within the scope of the appended claims.

The entire disclosure of Japanese Patent Application No. 8-231517 filed on August 13, 1996 including specification, claims, drawings and summary are incorporated herein by reference in its entirety.

## Claims

1. A superconducting film structure comprising an oxide superconductor layer and a protective layer which covers and protects a surface of the oxide superconductor layer.

2. A superconducting film structure as claimed in Claim 1, wherein the protective layer is formed of STO, BTO, or BSTO.

3. A superconducting film structure as claimed in Claim 2, wherein the protective layer is formed of more than two oxides selected from a group consisting of STO, BTO, and BSTO.

4. A superconducting film structure as claimed in Claim 2, wherein the protective layer is formed of BaₓSr₁₋ₓTiO₃ (0≤x≤1) in which x has the largest value at a side contact with the oxide superconducting layer, the smallest value at the opposite side and continuously decreases with distance from the oxide superconducting layer increasing.

5. A superconducting film structure as claimed in Claim 1, wherein the superconducting film structure further comprises a metal layer on the protective layer, which is alloyed with the protective layer so that the metal layer is electrically connected to the oxide superconductor layer.

6. A superconducting device comprising a layered structure having a lower layer of an oxide superconductor and an upper layer of a material different from the oxide superconductor wherein the upper layer protects the oxide superconductor layer.

7. A superconducting device as claimed in Claim 6 wherein the superconducting device is a super-FET and the oxide superconductor layer comprises a superconducting channel and the upper layer comprises a gate insulator of the super-FET.

8. A method for preparing on a substrate a superconducting film structure comprising a lower thin film composed of an oxide superconductor and a protective layer composed of a material different from the oxide superconductor which covers and protects a surface of the oxide superconductor layer wherein the protective layer is formed without breaking the vacuum and without transfer of the substrate.

9. A method as claimed in Claim 8, wherein a layer of metal is further formed on the protective layer with heating the substrate so that the metal alloys with the protective layer, which electrically connects the metal layer to the oxide superconductor layer.

10. A method as claimed in Claim 9, wherein the substrate is heated after the metal layer is formed so as to stimulate the alloying.
